# EUROPEAN PATENT SPECIFICATION

(11) **EP 4 261 881 B1**
(45) Date of publication and mention of the grant of the patent: **24.12.2025**
(21) Application number: 22167633.1
(22) Date of filing: 11.04.2022
(51) Int. Cl.: H01L 23/495, H05K 3/32, H05K 3/30

(54) **SEMICONDUCTOR PACKAGE COMPRISING AN EXTERNAL LEAD WITH A BARB PORTION**
HALBLEITERGEHÄUSE MIT EINER ÄUSSEREN LEITUNG MIT EINEM WIDERHAKEN
BOÎTIER DE SEMI-CONDUCTEUR COMPRENANT UN CONDUCTEUR EXTERNE AVEC UNE PARTIE D'ARDILLON

(43) Date of publication of application: 18.10.2023
(73) Proprietor: Infineon Technologies Austria AG, 9500 Villach (AT)
(72) Inventor: NIKITIN, Ivan, 93057 Regensburg (DE); LUNIEWSKI, Peter, 85586 Poing (DE)
(74) Representative: Lambsdorff & Lange Patentanwälte Partnerschaft mbB

(56) References cited:
- JP-A- 2003 007 380
- JP-A- H01 235 360
- JP-A- H03 255 654

## Description

### TECHNICAL FIELD

This disclosure relates in general to a semiconductor package comprising an external lead with a barb portion.

### BACKGROUND

Semiconductor modules or systems may comprise a semiconductor package and a printed circuit board (PCB), wherein the semiconductor package is connected to the PCB using wave soldering or selective soldering. Such modules or systems may further comprise a heatsink which may for example be arranged on the semiconductor package opposite to the PCB. Proper alignment of these components relative to each other may be impaired for example by PCB bend, package bend, shifting during transport prior to soldering or shifting during the soldering process, etc. All these factors may result in a module having misaligned components which in turn may for example increase the thermal resistance of the module. Improved semiconductor packages, improved methods for fabricating semiconductor packages, improved modules and improved methods for fabricating such modules may help in solving these and other problems. JP H01 235360 A (RICOH KK) 20 September 1989 (1989-09-20) discloses a semiconductor package having external leads with hook parts designed to enhance mounting density by mounting the package above another package on a printed circuit board. JP H03 255654 A (NEC CORP) 14 November 1991 (1991-11-14) discloses a surface mounting semiconductor device with a fixing terminal. This terminal is used for temporarily holding the device during the mounting process. JP 2003 007380 A (MICROJENICS INC) 10 January 2003 (2003-01-10) discloses an electronic component having leads with outward hooking parts which provides accurate positioning when mounting the component on a circuit board.

The problem on which the invention is based is solved by the features of the independent claim. Further advantageous examples are described in the dependent claims.

### SUMMARY

Various aspects pertain to a system, comprising:semiconductor package, comprising:a semiconductor die,a molded body encapsulating the semiconductor die, and a plurality of external leads exposed from the molded body, the external leads being leadframe parts, wherein at least a first one and a second one of the plurality of external leads comprise a barb portion, the barb portion having a greater width than an innermost portion and a through hole portion of the respective external lead, the innermost portion extending from the molded body to the through hole portion, the through hole portion extending between the innermost portion and the barb portion, the through hole portion being configured to extend through a through hole of a printed circuit board, and the barb portion being configured to interlock with a surface of the printed circuit board around the through hole, and a printed circuit board, wherein the semiconductor package is arranged on the printed circuit board such that a second side of the molded body is in direct contact with a first side of the printed circuit board, and wherein the barb portions of the at least first one and second one of the external leads keep the semiconductor package in place on the printed circuit board, and wherein the barb portions pull the printed circuit board against the second side of the molded body such that a warpage of the printed circuit board is countered.

### BRIEF DESCRIPTION OF THE DRAWINGS

The elements of the drawings are not necessarily to scale relative to each other. Identical reference numerals designate corresponding similar parts.
Figures 1A and 1B show a sectional view (Fig. 1A) and a side view (Fig. 1B) of a semiconductor package comprising an external lead with a barb portion.
Figure 2 shows a detail view of an external lead with a barb portion.
Figure 3 shows a side view of a system or module comprising a semiconductor package and a PCB.
Figure 4 shows a perspective view of a detail of the system of Fig. 3, according to an example.
Figure 5 shows a perspective view of a detail of the system of Fig. 3, according to another example.
Figure 6 shows exemplary through holes and external leads with barb portions arranged in the through holes.
Figure 7 is a flow chart of a method for fabricating a semiconductor package.
Figure 8 is a flow chart of a method for fabricating a system or module.

### DETAILED DESCRIPTION

In the following detailed description, known structures and elements are shown in schematic form in order to facilitate describing one or more aspects of the disclosure. In this regard, directional terminology, such as "top", "bottom", "left", "right", "upper", "lower" etc., is used with reference to the orientation of the Figure(s) being described. Because components of the disclosure can be positioned in a number of different orientations, the directional terminology is used for purposes of illustration only.

In addition, while a particular feature or aspect of an example may be disclosed with respect to only one of several implementations, such feature or aspect may be combined with one or more other features or aspects of the other implementations as may be desired and advantageous for any given or particular application, unless specifically noted otherwise or unless technically restricted. Furthermore, to the extent that the terms "include", "have", "with" or other variants thereof are used in either the detailed description or the claims, such terms are intended to be inclusive in a manner similar to the term "comprise". The terms "coupled" and "connected", along with derivatives thereof may be used. It should be understood that these terms may be used to indicate that two elements cooperate or interact with each other regardless whether they are in direct physical or electrical contact, or they are not in direct contact with each other; intervening elements or layers may be provided between the "bonded", "attached", or "connected" elements. However, it is also possible that the "bonded", "attached", or "connected" elements are in direct contact with each other. Also, the term "exemplary" is merely meant as an example, rather than the best or optimal.

An efficient semiconductor package, an efficient system and an efficient method for fabricating a semiconductor package or a system may for example reduce material consumption, ohmic losses, chemical waste, etc. and may thus enable energy and/or resource savings. Improved semiconductor packages, systems and methods for fabricating a semiconductor package or a system, as specified in this description, may thus at least indirectly contribute to green technology solutions, i.e. climate-friendly solutions providing a mitigation of energy and/or resource use.

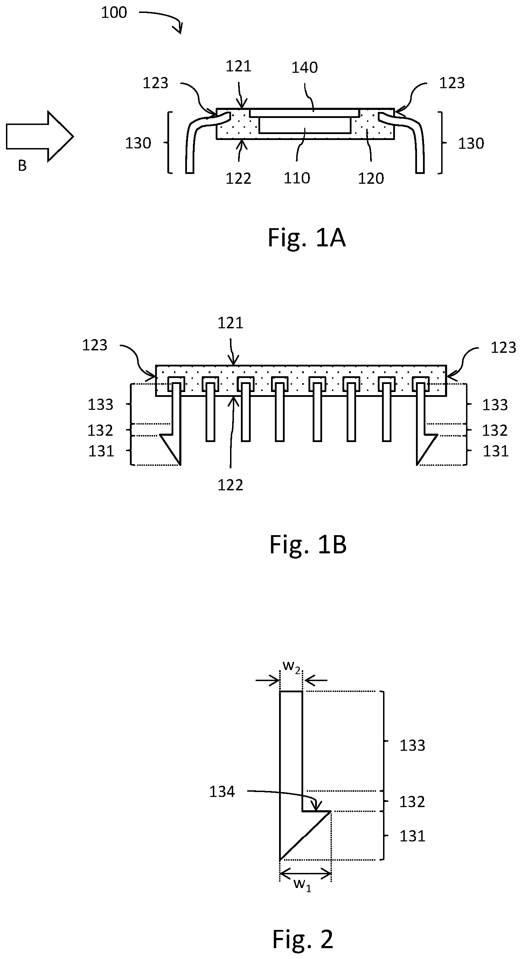

Figures 1A and 1B show a semiconductor package 100 comprising a semiconductor die 110, a molded body 120 and a plurality of external leads 130. Fig. 1A shows a sectional view and Fig. 1B shows a side view along the arrow B in Fig. 1A.

The semiconductor die 110 may be any suitable type of die, e.g. a MOSFET or an IGBT. The semiconductor die 110 may be a power die configured to operate with a high voltage and/or a high electrical current. The semiconductor package 100 may for example comprise a plurality of semiconductor dies 110 which may be the same type of dies or different types of dies. The plurality of semiconductor dies 110 may for example be coupled to provide a circuit like an inverter circuit, a converter circuit, a half-bridge circuit, etc. Furthermore, the semiconductor package 100 may be a power semiconductor package.

The molded body 120 encapsulates the semiconductor die 110. The molded body 120 may comprise or consist of any suitable dielectric material, in particular a mold material, a polymer, a resin, etc. The molded body 120 may further comprise filler particles, e.g. filler particles configured to reduce the thermal resistance of the molded body 120.

The external leads 130 are exposed from the molded body 120. According to an example, the molded body 120 comprises a first side 121, an opposite second side 122 and later sides 123 connecting the first and second sides 121, 122. The external leads 130 may for example extend from at least one of the lateral sides 123. However, it is also possible that at least some of the external leads 130 or all of the external leads 130 extend from the first side 121 or from the second side 122. According to an example, the semiconductor package 100 comprises two rows of external leads 130 which extend from the molded body 120 on two opposite lateral sides 123, as shown in Fig. 1A.

The external leads 130 are leadframe parts. This means that during fabrication of the semiconductor package 100, the external leads 130 are provided as part of a leadframe. Fabricating the semiconductor package 100 may for example comprise punching or stamping or cutting the leadframe in order to fabricate the external leads 130. According to an example, the external leads 130 are in particular no pressfit pins. Pressfit pins would increase the costs of the semiconductor package 100 and/or would have to be inserted into through holes with a greater expenditure of force than leadframe parts. The external leads 130 may for example comprise or consist of Al or Cu.

Apart from the external leads 130, the semiconductor package 100 may also comprise one or more additional leadframe parts. For example, the semiconductor package 100 may comprise one or more die carriers 140, wherein the one or more die carriers 140 are leadframe parts. During fabrication of the semiconductor package 100, the external leads 130 and the die carrier(s) 140 may be part of the same leadframe or part of different leadframes. Furthermore, one or more of the external leads 130 may be integral with at least one of the die carrier(s) 140.

The semiconductor die 110 may be arranged on the die carrier 140. Furthermore, the semiconductor die 110 may be electrically coupled to the die carrier 140. For example, the semiconductor die 110 may comprise an electrode on a main side facing the die carrier 140 and this electrode may be electrically coupled to the die carrier 140 via e.g. a solder joint or a sintered joint.

As shown in Fig. 1A, the die carrier(s) 140 may be at least partially exposed from the molded body 120, for example exposed from the first side 121 of the molded body 120. In this manner, a heatsink may be arranged at the first side 121 and no mold material is arranged between the die carrier(s) 140 and the heatsink. Alternatively, the die carrier(s) 140 are not exposed from the molded body 120.

The external leads 130 may for example comprise or consist of external power contacts, control contacts and/or sensor contacts of the semiconductor package 100. According to an example, the semiconductor package 100 comprises additional external contacts which may be different from the external leads 130. According to another example, the semiconductor package does not comprise any additional external contacts.

As shown in Fig. 1B, at least a first one and a second one of the plurality of external leads 130 comprise a barb portion 131. The barb portion 131 has a greater width than a through hole portion 132 and an innermost portion 133 of the respective external lead 130. The innermost portion 133 extends from the molded body to the through hole portion 132 and the through hole portion 132 extends between the innermost portion 133 and the barb portion 131. Furthermore, the through hole portion 132 is configured to extend through a through hole of a PCB and the barb portion 131 is configured to interlock with a surface of the PCB around the through hole.

According to an example, the semiconductor package 100 comprises at least four external leads 130 with barb portions 131. These four external leads 130 may for example be arranged at the four corners of the semiconductor package 100. According to another example, the semiconductor package 100 comprises at least two external leads 130 with barb portions, wherein these two external leads 130 are arranged at diagonally opposing corners of the semiconductor package 100. The semiconductor package 100 may in general comprise any suitable number of external leads 130 with barb portions 131. It is also possible that all of the external leads 130 have a barb portion 131.

A single one or some or even all of the external leads 130 with a barb portion 131 may have an electrical function as an external power contact, control contact or sensor contact of the semiconductor package 100. However, it is also possible that one or some or even all of the external leads 130 with a barb portion 131 do not have an electrical function (i.e. these leads are dummy leads that are not coupled to an electrical component of the semiconductor package 100, in particular not coupled to the semiconductor die 110).

The barb portions 131 of individual external leads 130 may have different orientations. As shown in Fig. 1B, the barb portions 131 (in particular, the barb portions 131 of external leads 130 on the same lateral side 123) may for example be oriented away from each other. According to another example, the barb portions 131 (in particular, the barb portions 131 of external leads 130 on the same lateral side 123) are oriented to face each other.

Figure 2 shows a detail view of an external lead 130 with a barb portion 131, according to an example. A first width w₁ of the barb portion may for example be about 1.5 times or 2 times or 3 times or more larger than a second width w₂ of the through hole portion 132 and the innermost portion 131. The through hole portion 132 and the innermost portion 133 may for example have the same second width w₂. The through hole portion 132 and/or the innermost portion 133 may for example have a second width w₂ of 0.5mm or more, or 1mm or more, or 2mm or more, or 3mm or more, or 5mm or more.

The barb portion 131 may comprise or consist of a pointed end of the external lead 130. The pointed end may for example comprise a first side being a straight extension of the through hole portion 132 and a second side being tapered with respect to the through hole portion 132. According to another example, the pointed end comprises first and second sides which are tapered with respect to the through hole portion 132. The first and second sides may for example intersect with an angle of 90° or less, or 60° or less, or 45° or less.

An inner end of the barb portion 131 may comprise an angled side 134 which may for example be arranged perpendicular to the through hole portion 132 and/or to the innermost portion 133. The angled side 134 may be configured to be in direct contact with a main side of a PCB when the external lead 130 extends through a through hole of the PCB. In this case, the angled side 134 may essentially be parallel to the main side of the PCB.

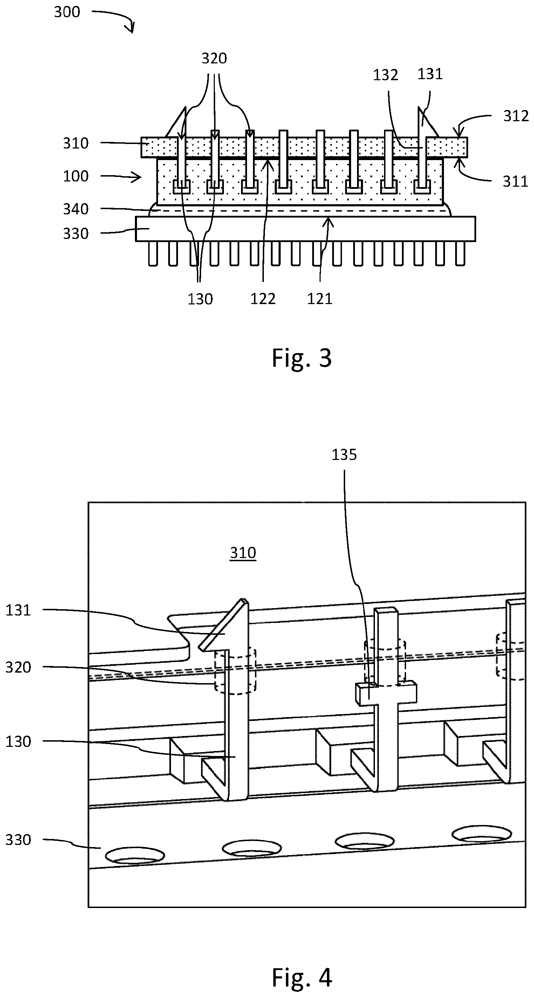

Figure 3 shows a side view of a system or module 300 comprising the semiconductor package 100 and a PCB 310 joined to the semiconductor package 100. The PCB 310 may comprise a first side 311 and an opposite second side 312, wherein the semiconductor package 100 is arranged at the first side 311.

As shown in Fig. 3, the PCB 310 comprises a plurality of through holes 320, wherein the external leads 130 extend into or even completely through the through holes 320. The barb portions 131 are arranged at the second side 312 of the PCB 310 and the through hole portions 132 are arranged within the through holes 320.

According to the present invention, the second side 122 of the molded body 120 is in direct contact with the first side 311 of the PCB 310.

Fabricating the system 300 may comprise arranging the PCB 310 on the semiconductor package 100 such that the external leads are arranged in the through holes 320 and then soldering the PCB 310 to the semiconductor package 100.

Once the PCB 310 is arranged on the semiconductor package 100, the barb portions 131 help in keeping the PCB 310 in place. In particular, the barb portions 131 prevent the PCB 310 from shifting out of position during transport, during soldering, etc.

Furthermore, according to the present invention, the barb portions 131 help in countering a potential warpage of the PCB 310 and/or a warpage of the semiconductor package 100. By pulling the PCB 310 into shape using the barb portions 131, a warpage may be remedied. This in turn may help in improving a thermal connection between the semiconductor package 100 and a heatsink arranged on the first side 121 of the molded body 120. By eliminating or at least reducing PCB warpage or package warpage, the alignment of the semiconductor package relative to the heatsink may be improved which may reduce the required minimum thickness of a layer of thermal interface material (TIM) between the semiconductor package 100 and the heatsink.

As shown in Fig. 3, barbed leads 130 may be longer than the non-barbed leads 130.

As shown in Fig. 3, the system 300 may comprise a heatsink 330 arranged at the first side 121 of the molded body 120. An intervening layer 340 e.g. comprising or consisting of TIM may be arranged between the molded body 120 and the heatsink 330. Since the relative positions of the semiconductor package 100 and the PCB 310 are fixed by the external leads 130 with barb portions 131, the no misalignment or almost no misalignment of these parts has to be accounted for during fabrication. For this reason, the intervening layer 340 may be thinner than it would have to be in the case that misalignments would have to be accounted for. This in turn reduces the thermal resistance between the semiconductor package 100 and the heatsink 330.

Figure 4 shows a perspective view of a detail of the system 300, according to a further example. Figure 4 in particular shows the external leads 130 arranged within the through holes 320 of the PCB 310 in greater detail.

As shown in Fig. 4, at least one of the external leads 130 may comprise a stopper portion 135. The stopper portion 135 has a larger width than the innermost portion 133 and the through hole portion 132 of that external lead 130. The stopper portion 135 is arranged between the innermost portion 133 and the through hole portion 132 of the respective external lead(s) 130. Furthermore, the stopper portion 135 is configured to prevent the external lead 130 from extending into through hole 320 of the PCB 310 beyond the through hole portion 132.

A width of the stopper portion 135 may for example be about two times or more, about three times or more, about four times or more, or about five times or more than the second width w₂. The width of the stopper portion 135 may for example be about the same as the first width w₁ or larger than w₁.

The stopper portion 135 may essentially have a T-shape or any other suitable shape. The stopper portion 135 may have an angled side which may be configured to be in direct contact with the first side 311 of the PCB 310. The width of the stopper portion 135 may in particular be larger than a diameter of the through hole 320.

According to an example, at least four of the external leads 130 of the semiconductor package 100 comprise a stopper portion 135. The four external leads 130 with stopper portions 135 may e.g. be arranged at the four corners of the semiconductor package 100. According to an example, all of the external leads 130 comprise a stopper portion 135.

The stopper portions 135 may for example be configured to provide a defined distance between the first side 311 of the PCB 310 and the second side 122 of the molded body 120. In other words, there may be a nonzero gap between the first side 311 and the second side 122.

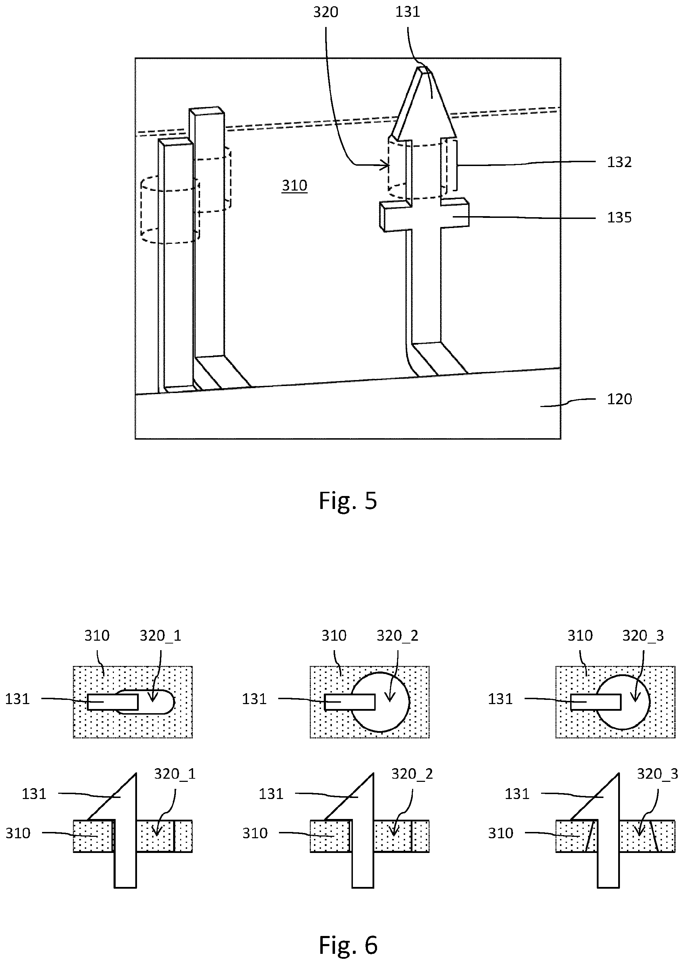

Figure 5 shows a perspective view of a detail of the system 300 according to another example. In the example shown in Fig. 5, an external lead 130 comprises both the barb portion 131 and the stopper portion 135. In the example shown in Fig. 4 on the other hand, an external lead with a barb portion 131 does not comprise a stopper portion 135 and vice versa.

Furthermore, the barb portion 135 of the example of Fig. 5 comprises a pointed end, wherein the pointed end is provided by first and second sides of the barb portion 135 which are tapered with respect to the through hole portion 132. The barb portion 135 of the example of Fig. 4 on the other hand comprises a pointed end, wherein a first side of the barb portion 135 a straight extension of the through hole portion 132 and a second side of the barb portion 135 is tapered with respect to the through hole portion 132.

Figure 6 shows different examples of through holes 320_1 to 320_3 which may be used in the system 300. Fig. 6 also shows an external lead 130 with a barb portion 131 arranged within each of the through holes 320_1 to 320_3. The top row of Fig. 6 shows a plan view of the through holes 320_1 to 320_3 and the bottom row of Fig. 6 shows a sectional view.

The through hole 320_1 comprises an essentially elongated shape, wherein the longer side may for example be as long or longer than the first width w₁ of the barb portion 131. The through hole 320_2 comprises an essentially round shape, wherein a diameter of the through hole 320_2 may for example be as larger or larger than the first width w₁. The through hole 320_3 comprises an essentially conical cross section, wherein at least the larger end of the conus may have a diameter that is as large or larger than w₁.

As shown in Fig. 6, a central axis of the through holes 320_1 to 320_3 may be shifted with respect to a central axis of the external lead 130 such that the barb portion 131 can hook into the PCB 310.

According to an example, the elongated through hole 320_1 or the through hole 320_2 with the large diameter may also have the conical cross section of the through hole 320_3.

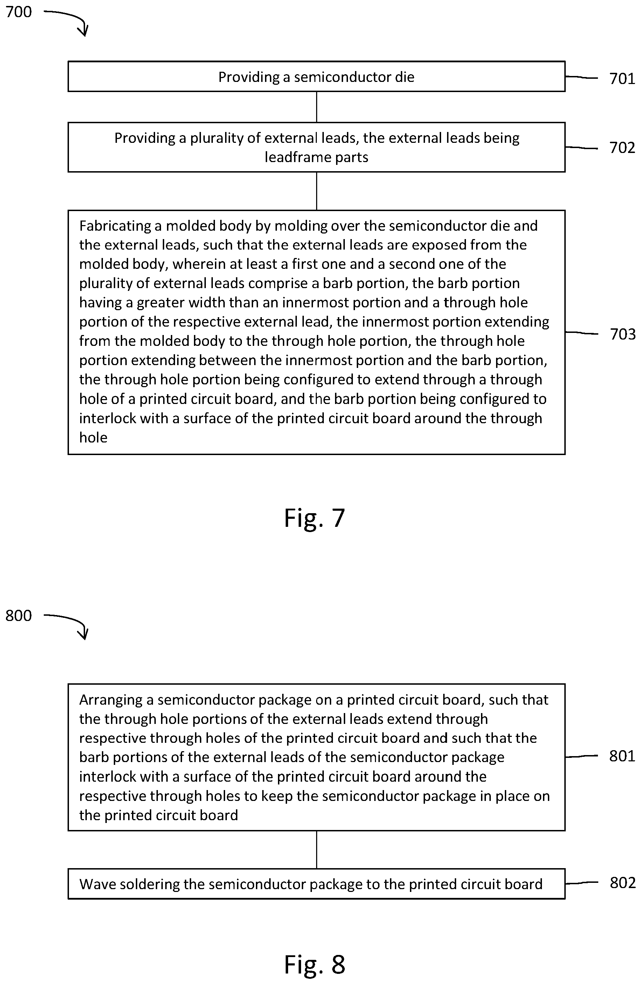

Figure 7 is a flow chart of a method 700 for fabricating a semiconductor package. The method 700 may for example be used to fabricate the semiconductor package 100.

The method 700 comprises at 701 an act of providing a semiconductor die, at 702 and act of providing a plurality of external leads, the external leads being leadframe parts, and at 703 an act of fabricating a molded body by molding over the semiconductor die and the external leads, such that the external leads are exposed from the molded body, wherein at least a first one and a second one of the plurality of external leads comprise a barb portion, the barb portion having a greater width than an innermost portion and a through hole portion of the respective external lead, the innermost portion extending from the molded body to the through hole portion, the through hole portion extending between the innermost portion and the barb portion, the through hole portion being configured to extend through a through hole of a printed circuit board, and the barb portion being configured to interlock with a surface of the printed circuit board around the through hole.

According to an example of the method 700, providing the plurality of external leads comprises an act of providing a sheet metal and an act of stamping or punching the sheet metal in order to fabricate the barb portions. The barb portions may in particular be fabricated in the same stamping or punching process that is used to fabricate the external leads and potentially a die carrier of the semiconductor package.

Figure 8 is a flow chart of a method 800 for fabricating a system. The method 800 may for example be used to fabricate the system 300.

The method 800 comprises at 801 an act of arranging a semiconductor package (e.g. the semiconductor package 100) on a printed circuit board, such that the through hole portions of the external leads extend through respective through holes of the printed circuit board and such that the barb portions of the external leads of the semiconductor package interlock with a surface of the printed circuit board around the respective through holes to keep the semiconductor package in place on the printed circuit board. The method 800 may at 802 optionally comprise an act of soldering the semiconductor package to the printed circuit board.

## Claims

1. A system (300), comprising:
semiconductor package (100), comprising:
a semiconductor die (110),
a molded body (120) encapsulating the semiconductor die (110), and
a plurality of external leads (130) exposed from the molded body (120), the external leads (130) being leadframe parts,
wherein at least a first one and a second one of the plurality of external leads (130) comprise a barb portion (131), the barb portion (131) having a greater width than an innermost portion (133) and a through hole (132) portion of the respective external lead (130),
the innermost portion (133) extending from the molded body (120) to the through hole portion (132),
the through hole portion (132) extending between the innermost portion (133) and the barb portion (131),
the through hole portion (132) being configured to extend through a through hole of a printed circuit board, and
the barb portion (131) being configured to interlock with a surface of the printed circuit board around the through hole, and the system further comprising the printed circuit board (310),
wherein the semiconductor package (110) is arranged on the printed circuit board (310) such that a second side (122) of the molded body (120) is in direct contact with a first side (311) of the printed circuit board (310), and
wherein the barb portions (131) of the at least first one and second one of the external leads (130) keep the semiconductor package (100) in place on the printed circuit board (310), and
wherein the barb portions (131) pull the printed circuit board (310) against the second side (122) of the molded body such that a warpage of the printed circuit board (310) is countered.

2. The system (300) of claim 1, wherein the semiconductor package (100) is arranged on the first side of the printed circuit board such that the plurality of external leads (130) extends into through holes of the printed circuit board and the barb portions (131) are arranged on a second side of the printed circuit board, opposite the first side.

3. The system (300) of claim 1 or 2, wherein at least two external leads (130) of the plurality of external leads (130) further comprise stopper portions (135) having a greater width than the innermost portions (133) and the through hole portions (132),
the stopper portions (135) being arranged between the innermost portions (133) and the through hole portions (132), and
the stopper portions (135) being configured to prevent the external leads (130) from extending into through holes of the printed circuit board beyond the through hole portions (132).

4. The system (300) of claim 3, wherein the first one and the second one of the external leads (130) comprise a stopper portion (135).

5. The system (300) of one of the preceding claims, wherein the first one and the second one of the external leads (130) are electrically insulated from the semiconductor die (110).

6. The system (300) of one of the preceding claims, wherein the barb portion (131) comprises a pointed end of the respective external lead (130).

7. The system (300) of claim 6, wherein the pointed end comprises a first side being a straight extension of the through hole portion (132) and a second side being tapered with respect to the through hole portion (132).

8. The system (300) of claim 6, wherein the pointed end comprises first and second sides being tapered with respect to the through hole portion (132).

9. The system (300) of one of the preceding claims, wherein the molded body (120) comprises the first side (121), an opposite second side (122) and lateral sides (123) connecting the first and second sides,
wherein the plurality of external leads (130) is exposed from the molded body (120) at one or more of the lateral sides (123).

## Patentansprüche

1. System (300), umfassend:
Halbleitergehäuse (100), umfassend:
einen ersten Chip (110);
einen Formkörper (120), der den Halbleiterchip (110) einkapselt, und
eine Vielzahl von externen Leitungen (130), die von dem Formkörper (120) freigelegt sind, wobei die externen Leitungen (130) Leiterrahmenteile sind,
wobei mindestens eine erste und eine zweite der Vielzahl von externen Leitungen (130) einen Widerhakenabschnitt (131) umfassen, wobei der Widerhakenabschnitt (131) eine größere Breite als ein innerster Abschnitt (133) und ein Durchgangslochabschnitt (132) der jeweiligen externen Leitung (130) aufweist,
wobei sich der innerste Abschnitt (133) von dem Formkörper (120) zu dem Durchgangslochabschnitt (132) hin erstreckt,
wobei sich der Durchgangslochabschnitt (132) zwischen dem innersten Abschnitt (133) und dem Widerhakenabschnitt (131) erstreckt,
wobei der Durchgangslochabschnitt (132) dazu ausgelegt ist, sich durch ein Durchgangsloch einer Leiterplatte zu erstrecken, und
wobei der Widerhakenabschnitt (131) dazu ausgelegt ist, eine Oberfläche der Leiterplatte um das Durchgangsloch herum in Eingriff zu nehmen, und
das System ferner umfassend die Leiterplatte (310),
wobei das Halbleitergehäuse (110) so auf der Leiterplatte (310) angeordnet ist, dass eine zweite Seite (122) des Formkörpers (120) in direktem Kontakt mit einer ersten Seite (311) der Leiterplatte (310) steht, und
wobei die Widerhakenabschnitte (131) mindestens der ersten und der zweiten der externen Leitung (130) das Halbleitergehäuse (100) auf der Leiterplatte (310) an Ort und Stelle halten, und
wobei die Widerhakenabschnitte (131) die Leiterplatte (310) derart gegen die zweite Seite (122) des Formkörpers ziehen, dass einer Verbiegung der Leiterplatte (310) entgegengewirkt wird.

2. System (300) nach Anspruch 1, wobei das Halbleitergehäuse (100) so auf der ersten Seite der Leiterplatte angeordnet ist, dass sich die Vielzahl von externen Leitungen (130) in Durchgangslöcher der Leiterplatte hinein erstreckt und die Widerhakenabschnitte (131) auf einer der ersten Seite gegenüberliegenden zweiten Seite der Leiterplatte angeordnet sind.

3. System (300) nach Anspruch 1 oder 2, wobei mindestens zwei externe Leitungen (130) der Vielzahl von externen Leitungen (130) ferner Anschlagabschnitte (135) mit einer größeren Breite als die innersten Abschnitte (133) und die Durchgangslochabschnitte (132) umfassen,
wobei die Anschlagabschnitte (135) zwischen den innersten Abschnitten (133) und den Durchgangslochabschnitten (132) angeordnet sind, und
wobei die Anschlagabschnitte (135) dazu ausgelegt sind, zu verhindern, dass sich die externen Leitungen (130) über die Durchgangslochabschnitte (132) hinaus in Durchgangslöcher der Leiterplatte erstrecken.

4. System (300) nach Anspruch 3, wobei die erste und die zweite der externen Leitungen (130) einen Anschlagabschnitt (135) umfassen.

5. System (300) nach einem der vorhergehenden Ansprüche, wobei die erste und die zweite der externen Leitungen (130) elektrisch von dem Halbleiterchip (110) isoliert sind.

6. System (300) nach einem der vorhergehenden Ansprüche, wobei der Widerhakenabschnitt (131) ein spitzes Ende der jeweiligen externen Leitung (130) umfasst.

7. System (300) nach Anspruch 6, wobei das spitze Ende eine erste Seite, die eine gerade Verlängerung des Durchgangslochabschnitts (132) ist, und eine zweite Seite, die in Bezug auf den Durchgangslochabschnitt (132) verjüngt ist, umfasst.

8. System (300) nach Anspruch 6, wobei das spitze Ende eine erste und eine zweite Seite umfasst, die in Bezug auf den Durchgangslochabschnitt (132) verjüngt sind.

9. System (300) nach einem der vorhergehenden Ansprüche, wobei der Formkörper (120) die erste Seite (121), eine dieser gegenüberliegende zweite Seite (122) und laterale Seiten (123), die die erste und die zweite Seite verbinden, umfasst,
wobei die Vielzahl von externen Leitungen (130) an einer oder an mehreren der lateralen Seiten (123) von dem Formkörper (120) freigelegt ist.

## Revendications

1. Système (300), comprenant :
un boîtier semi-conducteur (100), comprenant :
une puce semi-conductrice (110),
un corps moulé (120) encapsulant la puce semi-conductrice (110), et
une pluralité de broches externes (130) exposées depuis le corps moulé (120), les broches externes (130) étant des parties de grille de connexion,
au moins une première et une deuxième broche de la pluralité de broches externes (130) comprenant une partie barbe (131), la partie barbe (131) ayant une largeur supérieure à celle d'une partie la plus interne (133) et d'une partie trou traversant (132) de la broche externe respective (130),
la partie la plus interne (133) s'étendant depuis le corps moulé (120) jusqu'à la partie trou traversant (132),
la partie trou traversant (132) s'étendant entre la partie la plus interne (133) et la partie barbe (131),
la partie trou traversant (132) étant conçue pour s'étendre à travers un trou traversant d'une carte de circuit imprimé, et
la partie barbe (131) étant conçue pour s'enclencher avec une surface de la carte de circuit imprimé autour du trou traversant, et
le système comprenant en outre la carte de circuit imprimé (310),
dans lequel le boîtier semi-conducteur (110) est disposé sur la carte de circuit imprimé (310) de telle sorte qu'un deuxième côté (122) du corps moulé (120) est en contact direct avec un premier côté (311) de la carte de circuit imprimé (310), et
dans lequel les parties barbe (131) de l'au moins une première et une deuxième broche externe (130) maintiennent le boîtier semi-conducteur (100) en place sur la carte de circuit imprimé (310), et
dans lequel les parties barbe (131) tirent la carte de circuit imprimé (310) contre le deuxième côté (122) du corps moulé de telle sorte qu'un gauchissement de la carte de circuit imprimé (310) est compensé.

2. Système (300) de la revendication 1, dans lequel le boîtier semi-conducteur (100) est disposé sur le premier côté de la carte de circuit imprimé de telle sorte que la pluralité de broches externes (130) s'étend à l'intérieur de trous traversants de la carte de circuit imprimé et les parties barbe (131) sont disposées sur un deuxième côté de la carte de circuit imprimé, à l'opposé du premier côté.

3. Système (300) de la revendication 1 ou 2, dans lequel au moins deux broches externes (130) de la pluralité de broches externes (130) comprennent en outre des parties d'arrêt (135) ayant une largeur supérieure à celle des parties les plus internes (133) et des parties trou traversant (132),
les parties d'arrêt (135) étant disposées entre les parties les plus internes (133) et les parties trou traversant (132), et
les parties d'arrêt (135) étant conçues pour empêcher les broches externes (130) de s'étendre à l'intérieur de trous traversants de la carte de circuit imprimé au-delà des parties trou traversant (132).

4. Système (300) de la revendication 3, dans lequel la première et la deuxième des broches externes (130) comprennent une partie d'arrêt (135).

5. Système (300) d'une des revendications précédentes, dans lequel la première et la deuxième des broches externes (130) sont isolées électriquement de la puce semi-conductrice (110).

6. Système (300) d'une des revendications précédentes, dans lequel la partie barbe (131) comprend une extrémité pointue de la broche externe respective (130).

7. Système (300) de la revendication 6, dans lequel l'extrémité pointue comprend un premier côté qui est un prolongement rectiligne de la partie trou traversant (132) et un deuxième côté qui est conique par rapport à la partie trou traversant (132).

8. Système (300) de la revendication 6, dans lequel l'extrémité pointue comprend des premier et deuxième côtés qui sont coniques par rapport à la partie trou traversant (132).

9. Système (300) d'une des revendications précédentes, dans lequel le corps moulé (120) comprend le premier côté (121), un deuxième côté opposé (122) et des côtés latéraux (123) reliant les premier et deuxième côtés, dans lequel la pluralité de broches externes (130) est exposée depuis le corps moulé (120) au niveau d'un ou plusieurs des côtés latéraux (123).
